# EUROPEAN PATENT APPLICATION

(11) **EP 4 592 568 A1**
(43) Date of publication of application: **30.07.2025**
(21) Application number: 23868278.5
(22) Date of filing: 22.09.2023
(51) Int. Cl.: F16J 9/26, C23C 14/06

(54) **SLIDING MEMBER, METHOD FOR MANUFACTURING SAME, AND COATING FILM**

(30) Priority: 22.09.2022 JP 2022151785
(71) Applicant: Nippon Piston Ring Co., Ltd., Saitama-City, Saitama 338-8503 (JP)
(72) Inventor: SUGIURA, Hiroyuki, Saitama-shi, Saitama 338-8503 (JP); OZAKI, Takuya, Saitama-shi, Saitama 338-8503 (JP); OKAZAKI, Takahiro, Saitama-shi, Saitama 338-8503 (JP)
(74) Representative: Grünecker Patent- und Rechtsanwälte PartG mbB
(86) International application number: PCT/JP2023/034476
(87) International publication number: WO 2024/063157

(57) **Abstract**

To provide a novel sliding member exhibiting chipping resistance and wear resistance, having excellent peeling resistance, capable of realizing a reduction in friction, particularly less likely to chip or crack, and realizing homogenization and thickening with favorable productivity, and the like.

The above-described problem is solved by a sliding member (10) comprising a coating film (1) on a sliding surface (16) on a base material (11). The coating film (1) includes a plurality of laminated parts (3), and carbon layers (4) provided between each of the plurality of laminated parts (3). The plurality of laminated parts (3), when a cross section thereof is observed by a bright-field TEM image, are configured by laminating, in a thickness direction (Y), repeating units (2) of a black hard carbon layer (B) shown in a relatively black color or blackish color and a white hard carbon layer (W) shown in a relatively white color or whitish color. The carbon layers (4) each include a columnar structure (4c). The laminated part (3) preferably has a thickness within a range of 2 to 9 µm, and the coating film (1) preferably has a thickness within a range of 4 to 40 µm.

## Description

### Field of the Invention

The present invention relates to a sliding member, a manufacturing method thereof, and a coating film. Specifically, the present invention relates to a coating film exhibiting chipping resistance and wear resistance, having excellent peeling resistance (adhesion), capable of realizing a reduction in friction, particularly less likely to chip or crack, and realizing homogenization and thickening, a sliding member including the coating film, and a manufacturing method of the sliding member.

### BACKGROUND ART

In recent years, in various industrial fields, particularly in the automobile field, the study of hard carbon layers as coating films on surfaces of sliding members of an engine base material, another machine base material, or the like that require slidability is prevalent. The hard carbon layer is generally called by various names such as diamond-like carbon (DLC) layer, amorphous carbon layer, i-carbon layer, and diamond-like carbon layer. Such hard carbon layers are structurally classified as amorphous.

In the hard carbon layer, single bonds such as seen in diamond crystals, and double bonds such as seen in graphite crystals, are considered to co-exist. The hard carbon layer has properties such as high hardness, high wear resistance, and excellent chemical stability similar to those of the diamond crystals as well as properties such as low hardness, high lubricity, and excellent mated running-in property similar to those of the graphite crystals. Further, the hard carbon layer, being amorphous, has excellent flatness, low frictionality (that is, a small friction coefficient) in direct contact with a mated material, and excellent mated running-in property as well.

On a sliding surface of the sliding member, chipping resistance (defect resistance) and wear resistance are important properties. However, the chipping resistance (defect resistance) and wear resistance are in a trade-off relationship, making it difficult to provide a coating film that satisfies these. As means therefor, it has been studied that, a hard carbon layer having decreased hardness is provided, or a mixed layer of a hard carbon having low hardness and a hard carbon having high hardness is provided, achieving both chipping resistance and wear resistance.

Nevertheless, the present situation is that both chipping resistance and wear resistance are still not sufficiently achieved. In particular, even though a coating film provided to a sliding member such as a piston ring to which a high load is applied is required to have chipping resistance and wear resistance as well as low frictionality and peeling resistance, improvement of these properties is still insufficient. In recent years, various techniques have been proposed to address these issues.

For example, in Patent Document 1, there is proposed a technique that, even with a physical vapor deposition (PVD) method, makes it possible to form a thick hard carbon layer having excellent durability, and thus achieve both chipping resistance and wear resistance of the formed hard carbon layer and improve low frictionality and peeling resistance. This technique is one in which a coating film covers a surface of a base material and includes, when a cross section thereof is observed by a bright-field transmission electron microscope (TEM) image, a white hard carbon layer relatively shown in white and a black hard carbon layer relatively shown in black alternately laminated in a thickness direction and having a total film thickness greater than 1 µm and less than or equal to 50 µm, the white hard carbon layer including a region grown in a fan shape in the thickness direction.

Further, in Patent Document 2, there are proposed a sliding member including a coating film exhibiting constant and stable chipping resistance and wear resistance and having excellent peeling resistance (adhesion), and the coating film thereof. This technique is one in which a sliding member includes a coating film composed of a hard carbon layer on a sliding surface, and the coating film has, when a cross section thereof is observed by a bright-field TEM image, a thickness within a range of 1 µm to 50 µm, and is configured by laminating, in a thickness direction, repeating units including black hard carbon layers relatively shown in black and white hard carbon layers relatively shown in white, the coating film including an inclined region, provided on a base material side, where thicknesses of the white hard carbon layers of the repeating units gradually increase in a thickness direction, and a homogeneous region, provided on a surface side, where thicknesses of the white hard carbon layers of the repeating units are the same or substantially the same in the thickness direction, the inclined region having a V-shaped or radially grown form in the thickness direction, and the homogeneous region not having a V-shaped or radially grown form in the thickness direction.

### PRIOR ART DOCUMENTS

### Patent Documents

Patent Document 1: WO2017/104822A1
Patent Document 2: WO2018/235750A1

### SUMMARY OF THE INVENTION

### Problems to be Solved by the Invention

A coating film on a sliding member is required to have chipping resistance, wear resistance, low frictionality, and other properties, and is further expected to achieve a reduction in friction (friction loss). A hard carbon layer constituting the costing film is expected to be a material capable of realizing low friction.

The coating film requires thickening of the hard carbon layer to ensure that properties thereof, such as wear resistance, can be continually exhibited over a long period. However, simply increasing the thickness of the laminated parts obtained by laminating the repeating units including the black hard carbon layer and the white hard carbon layer described above makes it easier for stress (equivalent to strain) to accumulate in the laminated parts, and for this accumulated stress to lead to chipping or cracking in the coating film. Further, even if a thick coating film is obtained, if the quality of the film differs in each portion in the thickness direction, the properties of each portion change, and properties such as wear resistance may lose stability over time. Furthermore, even if a thick coating film is formed, the achievement is meaningless if the method used has poor productivity.

The present invention was made to solve the above-described problems, and an object thereof is to provide a novel sliding member exhibiting chipping resistance and wear resistance, having excellent peeling resistance (adhesion), capable of realizing a reduction in friction, particularly less likely to chip or crack, and realizing homogenization and thickening with favorable productivity, a manufacturing method thereof, and a coating film.

### Means for Solving the Problems

(1) A sliding member according to the present invention comprises a coating film on a sliding surface on a base material. The coating film includes a plurality of laminated parts, and carbon layers provided between each of the plurality of laminated parts. The plurality of laminated parts, when a cross section thereof is observed by a bright-field TEM image, are configured by laminating, in a thickness direction, repeating units of a black hard carbon layer shown in a relatively black color or blackish color and a white hard carbon layer shown in a relatively white color or whitish color. The carbon layers each include a columnar structure.

According to this invention, in a case in which the laminated parts are simply thickened, stress (strain) that tends to accumulate in the laminated parts can be alleviated by providing the carbon layers including the columnar structure between each of the laminated parts. As a result, it is possible to provide a sliding member in which chipping and cracking do not occur in the coating film even if the laminated parts are thickened. In the sliding member having such a structural form, a cross-sectional form of each laminated part appearing in the thickness direction of the coating film is homogeneous, and thus properties in the thickness direction are also considered homogeneous, making it possible to realize both homogenization and thickening with favorable productivity. It should be noted that the columnar structure is a structure in which a columnar form shown in a relatively black color or blackish color extends in the thickness direction in the carbon layer shown in a relatively white color or whitish color.

In the sliding member according to the present invention, each of the plurality of laminated parts has a thickness within a range of 2 to 9 µm, and the coating film has a thickness within a range of 4 to 40 µm. According to this invention, it is possible to increase the thickness of the laminated part to the thickness within the above-described range, further laminate the laminated parts with the carbon layers interposed therebetween, and set a total thickness of the coating film within the above-described range without chipping or cracking occurring in the coating film. It should be noted that, to obtain the coating film having a thickness of 4 to 40 µm by repeatedly laminating the laminated parts having a thickness of 2 to 9 µm with the carbon layers interposed therebetween, a number of the laminated parts having a thickness of 2 to 9 µm is set within a range of about 2 to 10, making it possible to obtain the coating film having the above-described thickness range.

In the sliding member according to the present invention, the carbon layer is formed by a black carbon layer shown in a relatively black color or blackish color and a white carbon layer shown in a relatively white color or whitish color, in this order, and the columnar structure shown in the relatively black color is present in the white carbon layer. The carbon layer is obtained by forming the laminated part having a predetermined thickness, pausing film formation for a certain period of time to allow a temperature thereof to become relatively low, and then resuming film formation under predetermined conditions. In such a carbon layer, the black carbon layer is formed in the initial stage of film formation, and the white carbon layer is formed afterwards. The columnar structure described above is present in the white carbon layer. The carbon layers having such a form are provided between the laminated parts, making it possible to alleviate the stress in the laminated parts and obtain a coating film that is less likely to chip or crack. It should be noted that the white carbon layer and the columnar structure appearing therein are conceivably low-density structures and thus conceivably act to alleviate the stress in the laminated parts.

In the sliding member according to the present invention, an [sp²/(sp²+sp³)] ratio of the black hard carbon layer is within a range of 0.05 to 0.75, an [sp²/(sp²+sp³)] ratio of the white hard carbon layer is larger than the [sp²/(sp²+sp³)] ratio of the black hard carbon layer and within a range of 0.20 to 0.80, and an [sp²/(sp²+sp³)] ratio of the white carbon layer in the carbon layer is within a range of 0.20 to 0.80.

In the sliding member according to the present invention, an initial carbon layer is formed as a lower layer before formation of the coating film.

In the sliding member according to the present invention, a laminated part inner carbon layer is formed in each of the plurality of laminated parts, on the white hard carbon layer and as a lower layer of the black hard carbon layer.

The sliding member according to the present invention further comprises a surface layer part serving as an outermost surface layer above the plurality of laminated parts, the surface layer part having a thickness of 0.1 to 10 µm.

In the sliding member according to the present invention, the sliding member is a piston ring.

(2) A coating film according to the present invention comprises a plurality of laminated parts, and carbon layers provided between each of the plurality of laminated parts. The plurality of laminated parts, when a cross section thereof is observed by a bright-field TEM image, are configured by laminating, in a thickness direction, repeating units of a black hard carbon layer shown in a relatively black color or blackish color and a white hard carbon layer shown in a relatively white color or whitish color. The carbon layers each include a columnar structure.

In the coating film according to the present invention, each of the plurality of laminated parts has a thickness within a range of 2 to 9 µm, and the coating film has a thickness within a range of 4 to 40 µm.

In the coating film according to the present invention, the carbon layer is formed by a black carbon layer shown in a relatively black color or blackish color and a white carbon layer shown in a relatively white color or whitish color, in this order, and the columnar structure shown in the relatively black color is present in the white carbon layer.

In the coating film according to the present invention, an initial carbon layer is formed as a lower layer before formation of the coating film.

In the coating film according to the present invention, a laminated part inner carbon layer is formed in each of the plurality of laminated parts, on the white hard carbon layer and as a lower layer of the black hard carbon layer.

The coating film according to the present invention further comprises a surface layer part serving as an outermost surface layer above the plurality of laminated parts, the surface layer part having a thickness of 0.1 to 10 µm.

(3) A manufacturing method of a sliding member according to the present invention is a manufacturing method of the sliding member described in any one of claims 1 to 5 that includes the coating film on the sliding surface on the base material. The coating film includes a plurality of laminated parts, and carbon layers provided between each of the plurality of laminated parts. The plurality of laminated parts, when a cross section thereof is observed by a bright-field TEM image, are configured by laminating, in a thickness direction, repeating units of a black hard carbon layer shown in a relatively black color or blackish color and a white hard carbon layer shown in a relatively white color or whitish color. The carbon layers each include a columnar structure, and are each obtained by forming a corresponding laminated part of the plurality of laminated parts having a predetermined thickness, pausing film formation for a certain period of time to allow a temperature thereof to become relatively low, and then resuming film formation under predetermined conditions.

### Effect of the Invention

According to the present invention, it is possible to provide a novel sliding member exhibiting chipping resistance and wear resistance, having excellent peeling resistance (adhesion), capable of realizing a reduction in friction, particularly less likely to chip or crack, and realizing homogenization and thickening with favorable productivity, a manufacturing method thereof, and a coating film.

### BRIEF DESCRIPTION OF THE DRAWINGS

Fig. 1 is a schematic sectional view illustrating an example of a sliding member according to the present invention.
Fig. 2 is a schematic enlarged sectional view illustrating an example of a coating film.
Fig. 3 is a bright-field TEM image of a cross section showing an example of the coating film.
Fig. 4 is a bright-field TEM image of an enlarged cross section of laminated parts constituting the coating film.
Fig. 5 is a bright-field TEM image of an enlarged cross section of carbon layers constituting the coating film.
Fig. 6 is a bright-field TEM image of a cross section showing an example of a surface layer part constituting the coating film.
Fig. 7 is a bright-field TEM image of an enlarged cross section of the surface layer part.
Fig. 8 is a schematic sectional view illustrating an example of a piston ring according to the present invention.
Fig. 9 is a schematic view of a friction-abrasion testing method by an SRV tester.

### Embodiments of the Invention

A sliding member, a manufacturing method thereof, and a coating film according to the present invention will now be described in detail with reference to the drawings. It should be noted that the present invention is not limited only to the following descriptions and drawings, and modifications within the scope of the gist are also included.

### [Sliding Member]

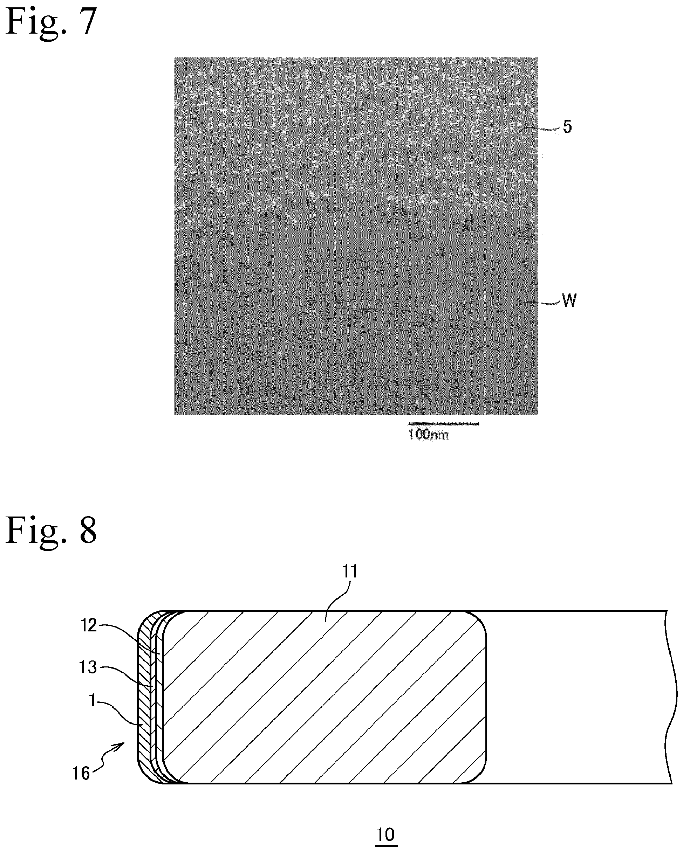

A sliding member 10 according to the present invention includes, for example, a coating film 1 on a sliding surface 16 on a base material 11, as illustrated in the example of a piston ring in Fig. 8. Then, the coating film 1 includes a plurality of laminated parts 3, and carbon layers 4 provided between each of the laminated parts 3. The plurality of laminated parts 3, when a cross section thereof is observed by a bright-field TEM image, are configured by laminating, in a thickness direction Y, repeating units 2 of a black hard carbon layer B shown in a relatively black color or blackish color and a white hard carbon layer W shown in a relatively white color or whitish color. The carbon layers 4 each include a columnar structure 4c.

In this sliding member 10, in a case in which the laminated parts 3 are simply thickened, stress (strain) that tends to accumulate in the laminated parts 3 can be alleviated by providing the carbon layers 4 including the columnar structure 4c between each of the laminated parts 3. As a result, even if the laminated parts 3 are thickened, an effect of chipping and cracking not occurring in the coating film 1 is exhibited. In the sliding member 10 having such a structural form, a cross-sectional form of each laminated part 3 appearing in a thickness direction Y of the coating film 1 is homogeneous, and thus properties in the thickness direction Y are also considered homogeneous, making it possible to realize both homogenization and thickening with favorable productivity. It should be noted that the columnar structure 4c is a structure in which a columnar form shown in a relatively black color or blackish color extends in the thickness direction Y in a white carbon layer 4b shown in a relatively white color or whitish color.

The bright-field TEM image can be obtained by observing the coating film 1 thinned by using a focused ion beam (FIB) through a transmission electron microscope (TEM) at an acceleration voltage of 300 kV, for example. The thickness direction Y means the direction in which the laminated parts 3 are repeatedly laminated on the base material 11 with the carbon layers 4 interposed therebetween. In a case of observation using this bright-field TEM image, with regard to the hard carbon layer and the carbon layer, this application may refer to "shown in a relatively white color or whitish color" as simply "white" and "shown in a relatively black color or blackish color" as simply "black."

The following describes the components of the sliding member 10 in detail. It should be noted that although, in the following, as an example of the sliding member 10, descriptions are often made using a piston ring (similarly denoted by reference sign 10), the sliding member 10 according to the present invention is not limited to the piston ring. Further, the [sp²/(sp²+sp³)] ratio may be abbreviated as "sp²/sp³ ratio."

### (Base material)

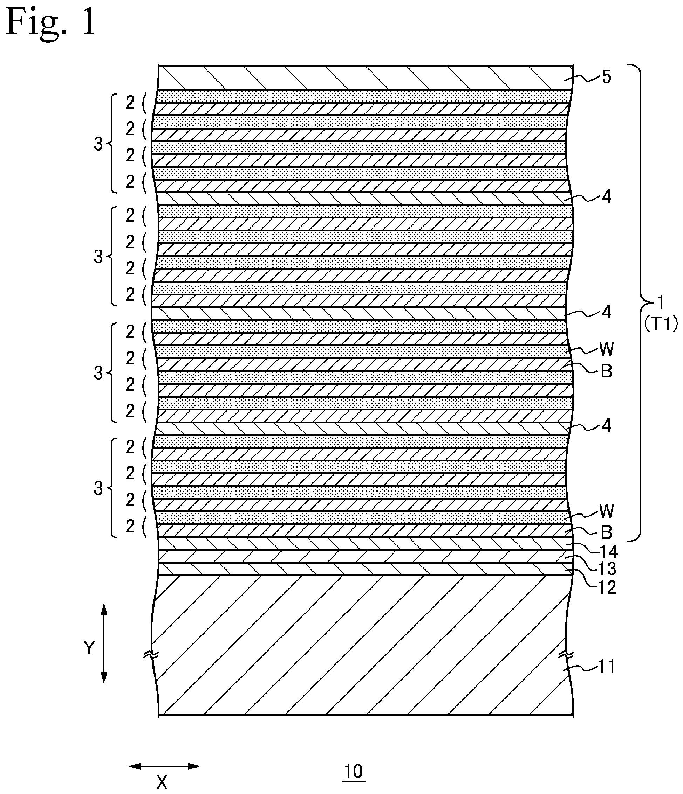

The base material 11 is a target member on which the coating film 1 is provided, as illustrated in Fig. 1. Further, the base material 11, while not particularly limited, may include a ferrous metal, a non-ferrous metal, a ceramic, a hard composite material, and the like. Examples include carbon steel, alloy steel, quenched steel, high-speed tool steel, cast iron, aluminum alloy, magnesium alloy, cemented carbide, and the like. It should be noted that, in consideration of a film forming temperature of the coating film 1, a base material having properties that do not significantly deteriorate at a temperature exceeding 200°C is preferred.

The base material 11 in a case in which the coating film 1 is applied to the piston ring 10 may include various materials used as the base material of the piston ring 10, and is not particularly limited. For example, various steel materials, stainless steel materials, casting materials, cast steel materials, and the like can be applied. Among these, a martensitic stainless steel, a chromium-manganese steel (SUP9 material), a chrome-vanadium steel (SUP10 material), a silicon-chromium steel (SWOSC-V material), and the like may be included. This base material 11 may include an underlayer 12 illustrated in Fig. 1 as necessary.

The base material 11 may be pretreated as necessary. Such a pretreatment is preferably performed by polishing a surface thereof to adjust surface roughness. Adjustment of the surface roughness is preferably performed by, for example, methods such as lapping and polishing the surface of the base material 11 using diamond abrasive grains. Such a base material 11 can be preferably applied as a pretreatment before formation of an intermediate layer 13 described later, or as a pretreatment for the underlayer 12 provided in advance before formation of the intermediate layer 13.

### (Underlayer)

The underlayer 12 is provided as necessary on the base material 11. Further, the underlayer 12 may include an underlayer that increases adhesion with the intermediate layer 13 described later or the like, and is not particularly limited. Specifically, the underlayer 12 may include a compound layer of nitride, carbonitride, carbide, or the like, composed of at least one of Cr, Ti, Si, Al, and the like and specifically may include CrN, CrBN, TiN, CrAlN, TiC, TiCN, TiAlSiN, and the like. The underlayer 12 can be formed by means such as a vacuum deposition method or an ion plating method of setting the base material 11 into a chamber, vacuating the chamber, and subsequently performing pre-heating, ion cleaning, and the like to introduce an inert gas, a nitrogen gas, or the like, for example. In addition, the underlayer 12 may be a nitrided layer (not illustrated) formed by performing a nitriding treatment. It should be noted that, because the piston ring 10 includes the coating film 1 exhibiting excellent wear resistance even without a compound layer or a nitrided layer, the underlayer 12 is not an essential component.

### (Intermediate layer)

The intermediate layer 13 is preferably provided as necessary between the base material 11 (the underlayer layer 12 in a case in which the underlayer 12 is provided) and the coating film 1, as illustrated in Fig. 1. By this intermediate layer 13, the adhesion between the base material 11 (underlayer 12) and the coating film 1 can be further improved. Further, the intermediate layer 13 may include a layer containing at least one or two or more elements of Cr, Ti, Si, W, B, and the like.

The intermediate layer 13 may include a titanium film, a chromium film, or the like. Further, the intermediate layer 13 may not necessarily be provided, and is optional. The intermediate layer 13 such as a titanium film or a chromium film can be formed by various film forming means such as a vacuum deposition method, a sputtering method, and an ion plating method. For example, the intermediate layer 13 can be formed by setting the base material 11 into a chamber, vacuating the chamber, and subsequently performing preheating, ion cleaning, and the like to introduce an inert gas. A thickness of the intermediate layer 13 is not particularly limited, but is preferably within a range of 0.05 µm or greater and 2 µm or less. It should be noted that, the intermediate layer 13 is preferably formed on at least the outer peripheral sliding surface 16 on which the piston ring 10 slides upon contact with a cylinder liner (not illustrated), but may be formed on other surfaces, such as an upper surface, a lower surface, or an inner peripheral surface of the piston ring 10, for example.

The intermediate layer 13 may be formed directly on the base material 11 or may be formed on the underlayer 12. Further, the intermediate layer 13 can improve the adhesion between the base material 11 (underlayer 12) and the coating film 1. It should be noted that, to further improve the adhesion and the like between the intermediate layer 13 and the coating film 1 as well, another layer may be provided as needed. For example, a film having the same or substantially the same components as those of the coating film 1 described later may be formed as a hard carbon base film.

### (Initial carbon layer)

More preferably, an initial carbon layer 14 is provided, as necessary, on the base material 11 before formation of the coating film as illustrated in Fig. 1, on the underlayer 12 in a case in which the underlayer 12 is provided, or on the intermediate layer 13 in a case in which the intermediate layer 13 is further provided. It should be noted that, in experimental examples described later, the initial carbon layer 14 is provided on the intermediate layer 13.

The film forming conditions of the initial carbon layer 14 are not particularly limited, but formation can be achieved by a film forming treatment (bombardment treatment using arc ion plating method) described in the experimental examples described later. The bombardment treatment is a treatment that uses a carbon target, can be expected to improve the adhesion of the coating film 1, and thus desirably is preferably applied in the present invention. The film forming conditions in the experimental examples are an example, and a bias voltage and an arc current as well as a treatment start temperature and a treatment time can be set as desired. The bias voltage of the initial carbon layer 14 is not particularly limited, but is preferable within a range of -600 to -1000 V and, in an example described later, as an example of the bombardment treating conditions, film formation is performed at a bias voltage of -750 V and an arc current of about 40 A for a predetermined time to reach a film thickness of approximately 0.2 µm before formation of the coating film 1. A thickness of the initial carbon layer 14 is not particularly limited, but is preferably within a range of 0.05 µm or greater and 0.5 µm or less.

### (Coating film)

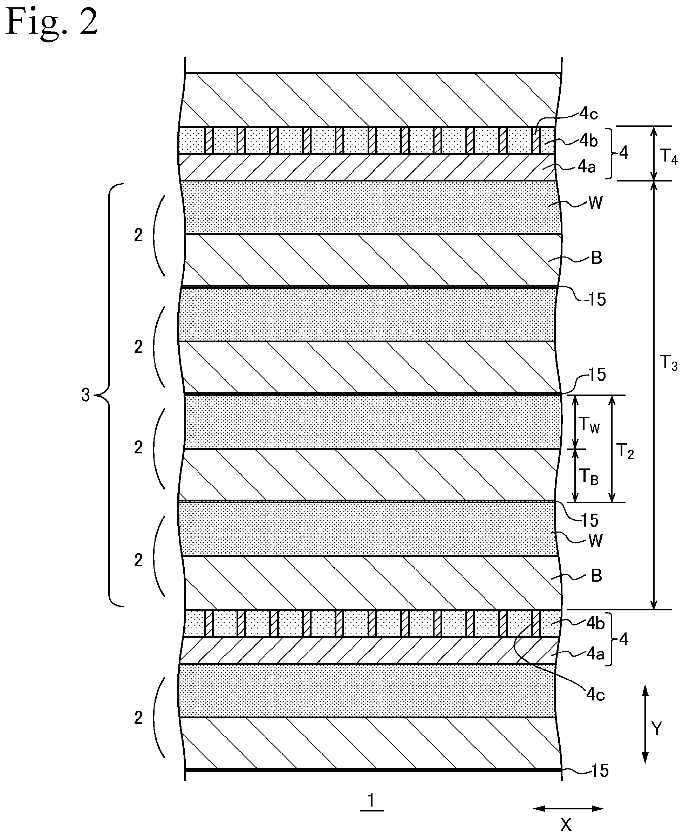

The coating film 1 includes a plurality of the laminated parts 3 and the carbon layers 4 provided between each of the laminated parts 3, as illustrated in Fig. 1 and Fig. 2. The laminated part 3 includes two types of hard carbon layers (reference sign W, reference sign B) shown relatively in the two colors of white and black when a cross section thereof is observed by a bright-field TEM image. The black hard carbon layer B and the white hard carbon layer W are laminated to constitute the repeating unit 2, and the repeating units 2 are laminated in the thickness direction Y to form the laminated part 3. It should be noted that, as previously described, the term "relatively" means the relative relationship of the hues when the cross section is observed by a bright-field TEM image, and the layer shown in the black color or the blackish color is the "black hard carbon layer B" and the layer shown in the white color or the whitish color is the "white hard carbon layer W."

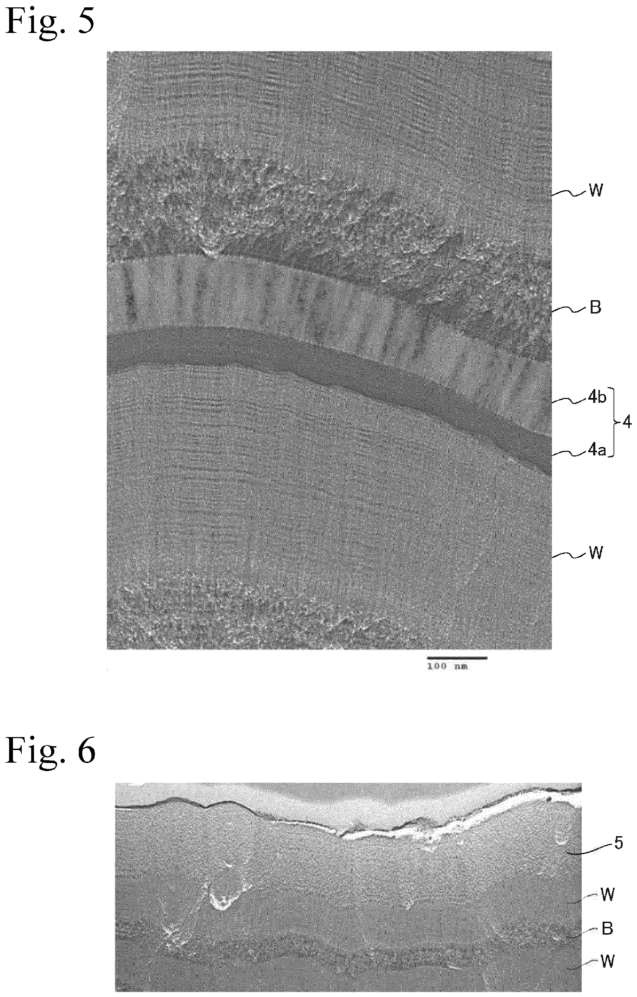

In a case in which the coating film 1 is applied to the piston ring 10, the coating film 1 is formed on at least the outer peripheral sliding surface 16 on which the piston ring 10 slides upon contact with a cylinder liner (not illustrated), as shown in Fig. 6. It should be noted that the coating film 1 may be formed as desired on other surfaces, such as the upper surface, the lower surface, and the inner peripheral surface of the piston ring 10, for example, as well.

### (Laminated part)

The laminated part 3, as illustrated in Fig. 1, Fig. 2, and Fig. 3, is formed by laminating the repeating unit 2 of the black hard carbon layer B and the white hard carbon layer W. The laminated order of the black hard carbon layer B and the white hard carbon layer W is not particularly limited. In the example in Fig. 1 and Fig. 2, the repeating unit 2 obtained by forming the black hard carbon layer B and then forming the white hard carbon layer W thereon is laminated, but the repeating unit 2 obtained in a reverse form thereof, that is, by forming the white hard carbon layer W and then forming the black hard carbon layer B thereon, may be laminated. The black hard carbon layer B and the white hard carbon layer W constituting the repeating unit 2 are formed in a mode of being adjacent to each other.

The black hard carbon layer B, similar to the related art, relatively has high density, a small sp²/sp³ ratio, and excellent strength, and the white hard carbon layer relatively has low density, a large sp²/sp³ ratio, and excellent low frictionality and chipping resistance. However, the laminated part 3 constituting the coating film 1 according to the present invention has a hardness different from that of the related art and, in the black hard carbon layer B and the white hard carbon layer W adjacent to each other, the white hard carbon layer W has a hardness higher than that of the black hard carbon layer B. That is, the black hard carbon layer B has low hardness and high density as compared with those of the white hard carbon layer W adjacent thereto. Conversely, the white hard carbon layer W has high hardness and low density as compared with those of the black hard carbon layer B adjacent thereto.

The sp²/sp³ ratio is larger in the white hard carbon layer W than in the black hard carbon layer B. More specifically, the black hard carbon layer B has low hardness, a small sp²/sp³ ratio, and high density as compared with those of the white hard carbon layer W adjacent thereto. The white hard carbon layer W has high hardness, a large sp²/sp³ ratio, and low density as compared with those of the black hard carbon layer B adjacent thereto. The laminated part 3 configured by laminating such a repeating unit 2 of the black hard carbon layer B and the white hard carbon layer W makes, as indicated by the results of the experimental examples, it possible to obtain the sliding member 10 excellent in chipping resistance, wear resistance, and peeling resistance (adhesion) on the basis of the laminating effect of the hard carbon layers B, W having different properties. It should be noted that the sp²/sp³ ratio is an abbreviation of the [sp²/(sp²+sp³)] ratio, and is measured by a method described in the explanation section of the "sp²/sp³ ratio" described later.

With regard to hardness, a Vickers hardness of the black hard carbon layer B is preferably within a range of 700 to 1600 HV, and more preferably within a range of 750 to 1200 HV. A Vickers hardness of the white hard carbon layer W is preferably higher than the Vickers hardness of the adjacent black hard carbon layer B and within a range of 1200 to 2200 HV, and more preferably within a range of 1250 to 1900 HV.

With regard to the sp²/sp³ ratio, the sp²/sp³ ratio of the black hard carbon layer B is preferably within a range of 0.05 to 0.75. The sp²/sp³ ratio of the white hard carbon layer W is preferably larger than the sp²/sp³ ratio of the black hard carbon layer B and within a range of 0.20 to 0.80. While the black hard carbon layer B having a small sp²/sp³ ratio has a relatively large number of carbon bonds (sp³ bonds), represented by diamond, and thus has high density and therefore high hardness, in the present invention, the density is high, but the hardness is low. On the other hand, while the white hard carbon layer W having a large sp²/sp³ ratio has a relatively large number of carbon bonds (sp² bonds), represented by graphite, and thus has low density and therefore low hardness, in the present invention, the density is low, but the hardness is high. This is considered to be caused by the film forming process described later. It should be noted that sp² and sp³ can be measured by a TEM-EELS obtained by combining electron energy-loss spectroscopy (EELS) with a transmission electron microscope (TEM). It should be noted that "high," "low," "large," and "small" here mean relatively high or low and large or small between the black hard carbon layer B and the white hard carbon layer W.

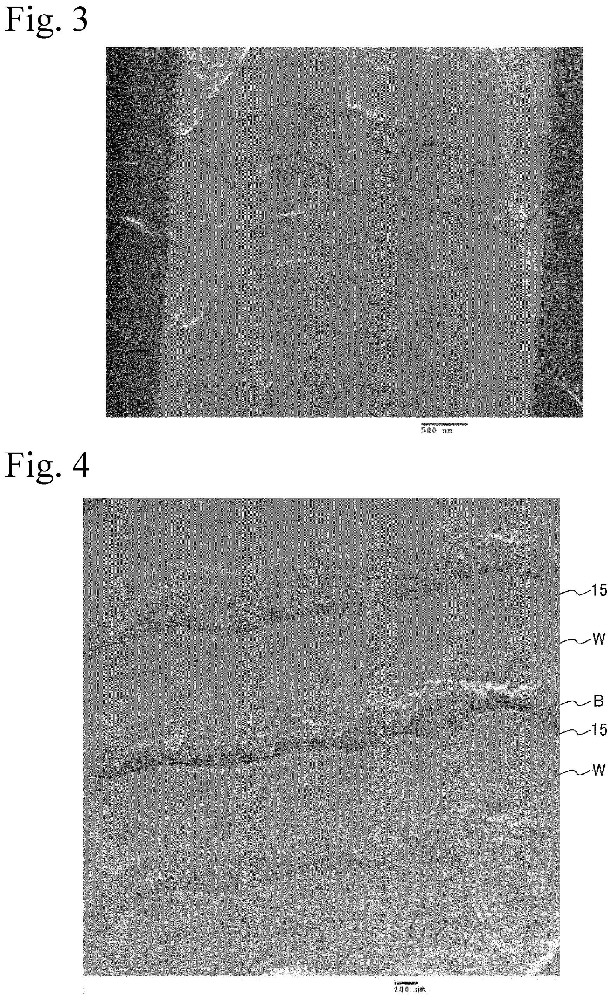

The black hard carbon layer B has a reticular or fan-shaped structural form in whole or in part, as shown in Fig. 4. The term "in part" refers to a portion of a surface layer side of the black hard carbon layer B, which may have a slight reticular or fan-shaped structural form, or a three-dimensional growth form that can be described as reticular or fan-shaped. With the growth form, the black hard carbon layers B may contain the white hard carbon. Further, the triangular-wave form of the black hard carbon layers B can also be seen as a V-shape (a form that widens from the position of the pivot of the fan toward the end) or a radial shape with respect to the growth direction of the film.

As shown in Fig. 4, the white hard carbon layer W can be visually recognized as having a fine striped pattern, and similarly the black hard carbon layer B can also be visually recognized as having a fine reticular shape. The reason that the individual layers (white hard carbon layer W, black hard carbon layer B) in which such a striped pattern is repeated are visually recognized is conceivably based on the fact that the distance to the target changes continuously when the film is formed by being rotated, as in a case in which the laminated part 3 is formed on the sliding surface of a piston ring having a ring shape.

The laminated part 3 can be formed by alternately performing film formation at 200°C or less and at above 200°C, for example, as the film forming temperature (substrate temperature) in a physical vapor deposition (PVD) method. The film is formed at 200°C or less, obtaining the white hard carbon layers W having a slightly large sp²/sp³ ratio. On the other hand, the film is formed at above 200°C, obtaining the black hard carbon layers B having a small sp²/sp³ ratio. Further, the laminated part 3 can be formed by alternately laminating these films (W, B).

It should be noted that, in a portion of the laminated part 3, a raised shape (not illustrated) across at least two or more laminated layers (W, B) may appear. This raised shape is a portion seen as a form with a stratum raised, and as a particle or balloon shape as well. In a case in which the raised shape exists, the laminated part 3 is not aligned in the thickness direction Y or uniformly laminated, and thus the raised shape readily appears mainly in the upper half and the laminated state is seen as disarranged. However, the properties such as wear resistance and chipping resistance are not significantly affected. The formation of the raised shape is conceivably started by macroparticles during film formation.

The black hard carbon layer B and the white hard carbon layer W constituting the laminated part 3 contain almost no hydrogen on the basis of the film forming conditions. If an attempt is made to estimate the hydrogen content, it can be said to be 0.01 atom% or greater and less than 5 atom%. The hydrogen content can be measured by hydrogen forward scattering spectrometry (HFS) analysis, and preferably the remnant is substantially carbon only and does not contain substances other than N, B, Si, and other inevitable impurities.

As seen in Fig. 4, a thin carbon layer 15 (also referred to as laminated part inner carbon layer 15) is formed in the laminated part, on the white hard carbon layer W and as a lower layer of the black hard carbon layer B. The thin carbon layer 15 is a carbon layer shown in a white color or a whitish color, and is different from the carbon layer 4 (inter-laminated-part carbon layer 4) and the initial carbon layer 14. Further, the thin carbon layer 15 is formed as a lower layer of the black hard carbon layer B when the black hard carbon layer B and the white hard carbon layer W are repeatedly formed to obtain the laminated part 3. A thickness of the thin carbon layer 15 is formed within a range of about 0.01 to 0.1 µm, for example. In addition, the thin carbon layer (laminated part inner carbon layer) 15 may be formed on the black hard carbon layer B and as a lower layer of the white hard carbon layer W.

### (Thickness)

With regard to a thickness ratio (TB/TW), the ratio (TB/TW) of a thickness TB of the black hard carbon layer B to a thickness TW of the white hard carbon layer W adjacent thereto is preferably within a range of 1/10 to 1.5/1, and more preferably within a range of 1/10 to 1/1. The thickness ratio (TB/TW) of the repeating unit 2 is within the above-described range, and thus can be controlled as desired and be made constant or varied in the thickness direction Y of the laminated part 3. The variation in the thickness ratio may be gradually increased or decreased, or may be set with the thickness ratio different from that of other portions at the start of film formation or at the end of film formation. From the perspective of realizing both homogenization and thickening with favorable productivity, the thickness ratio is preferably constant in the thickness direction Y.

In a case in which the ratio (TB/TW) of the thicknesses of the black hard carbon layer B and the white hard carbon layer W is the same in the thickness direction Y of the laminated part 3, the low frictionality and the chipping resistance of each repeating unit 2 are about the same in each portion in the thickness direction Y, the chipping resistance and the wear resistance are stabilized in each portion in the thickness direction even in a case in which wear of the laminated part 3 gradually progresses, and thus such a case is preferred. Further, for example, in a case in which the ratio (TB/TW) of the thicknesses of the black hard carbon layer B and the white hard carbon layer W is gradually varied in the thickness direction Y of the laminated part 3, the low frictionality and chipping resistance of the repeating unit 2 in the initial stage of sliding and the low frictionality and chipping resistance of the repeating unit 2 after the initial stage of sliding can be intentionally changed, and thus the chipping resistance and the wear resistance in a case in which the wear of the laminated part 3 gradually progresses can be controlled.

With regard to a thickness T, a thickness T2 of the repeating unit 2 is preferably within a range of 0.2 to 2 µm. The thicknesses T2 of the individual repeating units 2 can be controlled as desired and set within the above-described range, but from the perspective of realizing both homogenization and thickening in the thickness direction Y with favorable productivity, the thickness T2 of the repeating unit 2 is preferably constant in the thickness direction Y. A thickness T3 of the laminated part 3 is preferably within a range of 2 to 9 µm. The thickness T3 of the laminated part 3 can also be controlled as desired in the thickness direction Y and set within the above-described range, but from the perspective of realizing both homogenization and thickening in the thickness direction Y with favorable productivity, the thickness T3 of the laminated part 3 is preferably constant in the thickness direction Y. It should be noted that, from the perspective of thickening the coating film 1, a thickness T1 of the coating film 1 is preferably within a range of 4 to 40 µm. To set the thickness T1 of the coating film 1 within a range of 4 to 40 µm, a number of the laminated parts 3 having the thickness T3 of 2 to 9 µm is preferably within a range of about 2 to 10. The number of the laminated parts 3 is set within this range, making it possible to obtain the coating film 1 having the above-described thickness range.

### (Carbon layer)

The carbon layers 4 are provided between the laminated parts 3 (between the laminated part 3 and the laminated part 3), as illustrated in Fig. 1 and Fig. 2, and can also be referred to as the inter-laminated-part carbon layer. Further, the carbon layer 4 includes the columnar structure 4c as shown in Fig. 3 and Fig. 5. Such carbon layers 4 are provided between the laminated parts 3, making it possible to alleviate the stress (strain) that tends to accumulate in the laminated parts 3 in a case in which the laminated parts 3 are simply thickened. As a result, even if the laminated part 3 is thickened, it is possible to obtain the sliding member 10 in which chipping and cracking does not occur in the coating film 1. In the sliding member 10 having such a structural form, as shown in Fig. 3 and Fig. 4, a cross-sectional form of each laminated part 3 appearing in the thickness direction Y of the coating film 1 is homogeneous, and thus properties in the thickness direction Y are also considered homogeneous, making it possible to realize both homogenization and thickening with favorable productivity. It should be noted that the columnar structure 4c is a structure in which a columnar form shown in a relatively black color or blackish color extends in the thickness direction in a layer (white carbon layer 4b) shown in a relatively white color or whitish color.

The carbon layer 4, as more specifically shown in Fig. 5, is obtained by forming a black carbon layer 4a shown in a relatively black color or blackish color and the white carbon layer 4b shown in the relatively white color or whitish color in this order, and the columnar structure 4c shown in the relatively black color or blackish color is present in the white carbon layer 4b. Further, the carbon layer 4 is obtained by forming the laminated part 3 having a predetermined thickness, pausing film formation for a certain period of time to allow a temperature thereof to become relatively low, and then resuming film formation under predetermined conditions. In such a carbon layer 4, the black carbon layer 4a is formed in the initial stage of film formation, and the white carbon layer 4b is formed afterwards. The columnar structure 4c is generated in the white carbon layer 4b in the formation process of the carbon layer 4b. The carbon layers 4 having such a form are provided between the laminated parts 3, making it possible to alleviate the stress in the laminated parts 3 and obtain the coating film 1 that is less likely to chip or crack. It should be noted that the white carbon layer 4b and the columnar structure 4c appearing therein are conceivably low-density structures and thus conceivably act to alleviate the stress in the laminated parts 3. An [sp²/(sp²+sp³)] ratio of the white carbon layer 4b in such a carbon layer 4 is within a range of 0.20 to 0.80.

A thickness T4 of the carbon layer 4 is not particularly limited, but is preferably within a range of 0.05 to 0.5 µm. The thickness T4 is set within this range, making it possible to alleviate the stress accumulating in the laminated parts 3 and, even if the laminated parts 3 are thickened, obtain the sliding member 10 in which chipping or cracking does not occur in the coating film 1. With the thickness of the carbon layer 4 being less than 0.05 µm, the stress accumulating in the laminated parts 3 cannot be sufficiently alleviated and, in a case in which the laminated part 3 is thickened, chipping and cracking are likely to occur in the coating film 1. On the other hand, in a case in which the thickness of the carbon layer 4 exceeds 0.5 µm, the stress accumulating in the laminated parts 3 can be alleviated, but a thickness of 0.5 µm is sufficient for stress alleviation, and forming the carbon layer 4 having a thickness exceeding 0.5 µm increases the film forming time and reduces productivity. Therefore, an upper limit of the thickness T4 described above was specified from the perspective of productivity.

Fig. 5 shows a form example in which, when a thickness T4b of the white carbon layer 4b is compared with a thickness T4a of the black carbon layer 4a constituting the carbon layer 4, the white carbon layer 4b is thicker. However, the thickness T4a of the black carbon layer 4a and the thickness T4b of the white carbon layer 4b may be set to any thickness as long as the thicknesses are within the range of the thickness T4 of the carbon layer 4 described above. The thickness T4a of the black carbon layer 4a is not particularly limited, but can be set within a range of 0.01 to 0.34 µm, and the thickness T4b of the white carbon layer 4b is also not particularly limited, but can be set within a range of 0.016 to 0.4 µm.

The carbon layer 4, as described above, is formed after film formation is paused for a certain period of time to allow the temperature thereof to become relatively low, and thus the black carbon layer 4a appears during film formation at the low temperature stage, and the white carbon layer 4b appears during film formation as the temperature gradually increases. A thickness ratio (T4a:T4b) of the thickness T4a of the black carbon layer 4a and the thickness T4b of the white carbon layer 4b is affected by the film forming time and the film forming conditions of the carbon layer 4. In a case in which the film forming time of the carbon layer 4 is relatively short or under conditions in which the film forming speed is relatively slow (low bias voltage or arc current), the film forming temperature does not readily rise, facilitating formation of the black carbon layer 4a, and thus the thickness ratio (T4a:T4b) is within a range of 2:1 to 1:2. On the other hand, in a case in which the film forming time of the carbon layer 4 is relatively long or under conditions in which the film forming speed is relatively fast (relatively high bias voltage or arc current), the film forming temperature readily rises, facilitating formation of the white carbon layer 4b, and thus the thickness ratio (T4a:T4b) is within a range of 1:1 to 1:4. In the example in Fig. 5, it is understood that the thickness T4 of the carbon layer 4 is approximately 0.19 µm, and the thickness ratio (T4a:T4b) is approximately 1:1.9.

The columnar structure 4c is generated in the white carbon layer 4b. A generating mechanism of the columnar structure 4c is currently unknown, but the columnar structure 4c appears in the white carbon layer 4b when the temperature gradually rises during film formation of the carbon layer 4. This columnar structure 4c is a structure in which a columnar vertical streak shown in a relatively black color or blackish color extends in the thickness direction in the white carbon layer 4b. A feature of the present invention is that the white carbon layer 4b including the columnar structure 4c is provided between the laminated parts 3, and the effect of the present invention can be exhibited by such a carbon layer 4.

### (Surface layer part)

The surface layer part 5 is not an essential component of the coating film 1, but as illustrated in Fig. 1, is preferably provided as an outermost surface layer above the laminated parts 3. Similar to the white hard carbon layer W of the laminated part 3, the surface layer part 5 is further constituted by a hard carbon layer shown in a relatively white color when a cross section thereof is observed by a bright-field TEM image. The white hard carbon layer constituting the surface layer part 5 has a relatively large number of carbon bonds (sp² bonds), represented by graphite, and thus has low density and therefore low hardness. Such a surface layer part 5 is formed at a film forming temperature higher than that of the individual hard carbon layers (B, W) constituting the laminated part 3. A thickness of the surface layer part 5 is preferably within a range of 0.1 to 10 µm. The thickness of the surface layer part 5 is decreased to 0.1 µm or greater and less than 1.0 µm, making it possible to play a role in reducing friction when brought into contact with a mated member in the initial stage of sliding. Further, the thickness of the surface layer part 5 is increased to 1 to 10 µm, making it possible to play a role as a conforming layer with the mated member and a role in preventing damage to aluminum bores.

An sp²/sp³ ratio of the surface layer part 5 is within a range of 0.20 to 0.80, and preferably within a range of 0.30 to 0.60. With regard to the sp²/sp³ ratio, when the surface layer part 5 is compared with the black hard carbon layer B and the white hard carbon layer W constituting the laminated part 3, the magnitude relationship between the respective ratios is [the black hard carbon layer B < the white hard carbon layer W ≤ the surface layer part 5] or [the black hard carbon layer B < the surface layer part 5 ≤ the white hard carbon layer W]. Thus, the sp²/sp³ ratio of the surface layer part 5 composed of the white hard carbon layer is larger than that of the black hard carbon layer B and about the same as that of the white hard carbon layer W, and is the same as that of the white hard carbon layer W (laminated part 3) having the same relative color tone when a cross section thereof is observed by a bright-field TEM image.

The surface layer part 5 can be visually recognized as a fine-granular structure, as shown in Fig. 6 and Fig. 7. The reason for this structural form is not clear, but is conceivably depended on the film forming conditions of the surface layer part 5. Further, the surface layer part 5 contains almost no hydrogen on the basis of the film forming conditions. If an attempt is made to estimate the hydrogen content, it can be said to be 0.01 atom% or greater and less than 5 atom%. The hydrogen content can be measured by hydrogen forward scattering (HFS) analysis, and preferably the remnant is substantially carbon only and does not contain substances other than N, B, Si, and other inevitable impurities.

There is a significant difference in ranges of Vickers hardness between the surface layer part 5 and the white hard carbon layer W constituting the laminated part 3. The Vickers hardness of the surface layer part 5 in a case in which a thickness thereof is set to 0.1 µm or greater and less than 1.0 µm is lower than the Vickers hardness of the white hard carbon layer W of the laminated part 3, which is the same white hard carbon layer, and is within a range of 800 to 1200 HV. Then, the range (800 to 1200 HV) is about the same as the range (700 to 1600 HV) of the Vickers hardness of the black hard carbon layer B in the laminated part 3, but is within a relatively low range. It should be noted that, as described above, the Vickers hardness of the surface layer part 5 in a case in which the thickness thereof is increased to 1 to 10 µm is lower than the Vickers hardness of the white hard carbon layer W of the laminated part 3, which is the same white hard carbon layer, and the surface layer part 5 is preferably a film having a relatively low hardness within the range of 500 to 1000 HV, and more preferably within the range of 500 to 800 HV. The surface layer part 5 having such a Vickers hardness conceivably acts to reduce friction when brought into contact with the mated member in the initial stage of sliding, and play a role as a conforming layer with the mated member and a role in preventing damage to aluminum bores.

### (Formation of coating film)

The coating film 1 can be formed by applying a PVD method such as an arc-type PVD method or a sputtering PVD method. Among these, formation by an arc ion plating method that uses a carbon target and does not contain hydrogen atoms in the film forming raw material is preferred. In a case in which the coating film 1 is formed by an arc ion plating method, for example, the ON/OFF of the bias voltage, control of the bias voltage value, adjustment of the arc current, heating control of the base material by the heater, forced cooling of the base material in which a cooling mechanism is introduced in a jig (holder) for setting the base material, and the like can be set as the film forming conditions.

Specifically, in the laminated part 3, the black hard carbon layer B is formed by applying a high bias voltage, and the white hard carbon layer W is formed by applying a low bias voltage or no bias voltage. In the carbon layer 4, the laminated part 3 is formed, and film formation is paused for a certain period of time to allow the temperature thereof to become relatively low, and then resumed under predetermined conditions. In the surface layer part 5, the film is formed by applying a bias voltage equal to or higher than that of the black hard carbon layer B described above. Here, "high" and "low" bias voltages refer to the magnitude of the absolute value. For example, if -100 V and -50 V are used as examples, -100 V is the higher bias voltage.

In the laminated part 3, the black hard carbon layer B having an sp²/sp³ ratio of 0.05 to 0.75 is formed at a bias voltage that causes a temperature rise. The bias voltage can be set, for example, within a range of -100 to -300 V, the arc current at that time is within a range of 40 to 120 A, and the base material temperature is within a range of 100°C to 300°C. On the other hand, the white hard carbon layer W having an sp²/sp³ ratio of 0.20 to 0.80 is formed at a bias voltage that does not cause a temperature rise. The bias voltage can be set to 0 V or, for example, within a range greater than 0 V and less than or equal to -50 V, the arc current at that time is within a range of 40 to 120 A, and the base material temperature is not risen and is gradually reduced. It should be noted that the base material temperature can be adjusted by items other than the bias voltage as well, such as the arc current, the heater temperature, and the furnace pressure.

In the carbon layer 4, the film is formed by applying a bias voltage higher than those used for the formation of the black hard carbon layer B and the white hard carbon layer W constituting the laminated part 3. Specifically, the bias voltage is set within a range of -600 to - 1000 V, and the arc current is set to about 40 A. The reason for forming the carbon layer 4 under such conditions is that the carbon layer 4 is formed by pausing film formation of the laminated part 3 for a certain period of time to allow the temperature to become relatively low (for example, about 110°C), and then resuming film formation. The certain period of time paused is the time until the temperature becomes relatively low (for example, about 110°C).

The thickness of the surface layer part 5 is preferably within a range of 0.1 to 10 µm. The thickness of the surface layer part 5 is decreased to 0.1 µm or greater and less than 1.0 µm, making it possible to play a role in reducing friction when brought into contact with a mated member in the initial stage of sliding. Further, the thickness of the surface layer part 5 is increased to 1 to 10 µm, more preferably 1 to 8 µm, making it possible to play a role as a conforming layer with the mated member and a role in preventing damage to aluminum bores. In such a surface layer part 5, the film is formed by applying a bias voltage equal to or higher than that of the black hard carbon layer B described above. If the bias voltage during film formation of the black hard carbon layer B is, for example, -150 V, the bias voltage during film formation of the surface layer part 5 is set to a higher bias voltage (for example, -150 to - 400 V, preferably -150 to -250 V). Within this bias voltage range, the surface layer part 5 can be formed with the same form (fine-granulated) with no substantial differences confirmed. Then, during film formation at such a bias voltage, the film is formed by setting the film forming temperature higher than those of the individual hard carbon layers (B, W) constituting the laminated part 3.

### (sp²/sp³ ratio)

A hard carbon layer is a film in which carbon-bonding sp² bonds represented by graphite and carbon-bonding sp³ bonds represented by diamond coexist. In this application, by electron energy-loss spectroscopy (EELS) analysis, 1s -> π* intensity and 1s -> σ* intensity are measured and, with 1s -> π* intensity regarded as sp² intensity and 1s -> σ* intensity regarded as sp³ intensity, the ratio of 1s -> π* intensity to 1s -> σ* intensity is calculated as the [sp²/(sp²+sp³)] ratio (also abbreviated as "sp²/sp³ ratio"). Accordingly, the sp²/sp³ ratio in the present invention, to be exact, refers to the π/σ intensity ratio. Specifically, a spectral imaging method in a STEM (scanning TEM) mode is applied and, under the conditions of an acceleration voltage of 200 kV, a sample absorbing current of 10⁻⁹ A, and a beam spot size diameter of 1 nm, EELSs obtained at a pitch of 1 nm are integrated, a C-K absorption spectrum is extracted as average information from a region of approximately 10 nm, and the sp²/sp³ ratio is calculated.

### Examples

The following describes the coating film and the sliding member according to the present invention in further detail using experimental examples and comparative experimental examples.

### [Experimental Example 1]

A piston ring was applied as the sliding member 10. On the base material 11 (diameter of 88 mm, ring width in the radial direction of 2.9 mm, ring width in the axial direction of 1.2 mm) composed of C: 0.65 mass%, Si: 0.38 mass%, Mn: 0.35 mass%, Cr: 13.5 mass%, Mo: 0.3 mass%, P: 0.02 mass%, S: 0.02 mass%, and a remnant: iron and inevitable impurities, a nitrided layer of 40 µm was formed as the underlayer 12 by a nitriding treatment, and a metal chromium layer having a thickness of 0.2 µm was formed as the intermediate layer 13 by an ion plating method. Next, the initial carbon layer 14 having a thickness of 0.2 µm was formed on the intermediate layer 13 by bombardment treatment (bias voltage: -750 V, arc current: 40 A). The laminated part 3 was formed on this initial carbon layer 14. The laminated part 3, by using an arc ion plating device with a carbon target, was obtained by forming the repeating unit 2 having a thickness of 0.53 µm, which was constituted by the black hard carbon layer B having a thickness of approximately 0.18 µm and the white hard carbon layer W having a thickness of approximately 0.35 µm 10 times in succession, thereby bringing a thickness thereof to approximately 5.3 µm. Subsequently, after a pause of approximately 135 minutes, the carbon layer 4 having a thickness of approximately 0.19 µm was formed by using an arc ion plating device with the same carbon target. It should be noted that, after the pause of approximately 135 minutes, the base material temperature dropped to approximately 110°C. After formation of the carbon layer 4, the laminated part 3 having a thickness of approximately 5.3 µm was formed again, subsequently the carbon layer 4 having a thickness of approximately 0.19µm was formed again, and these operations were repeated. In the end, the laminated part 3 was formed five times, and the carbon layer 4 was formed between the laminated parts 3, and lastly the surface layer part 5 having a thickness of approximately 0.50 µm was formed on the laminated parts 3 to obtain the coating film 1 having a total thickness of approximately 27.8 µm.

Specifically, the black hard carbon layer B constituting the laminated part 3 was formed by performing arc discharge for 10 minutes at a bias voltage of -150 V and an arc current of 40 A. The white hard carbon layer W formed thereon was formed by performing arc discharge (arc current of 40 A) for 20 minutes at a bias voltage of -30 V. The carbon layers 4 formed between the laminated parts 3 were formed by performing arc discharge for 22 minutes at a bias voltage of -750 V and an arc current of 40 A. The surface layer part 5 was formed by performing arc discharge for 30 minutes at a bias voltage of -170 V and an arc current of 40 A.

### [Observation of Structural Form]

Bright-field TEM images of the cross section of the coating film 1 thus formed were taken. Cross-sectional images of the coating film 1 were obtained by taking images of the cross section of the coating film 1 using a bright-field TEM at an acceleration voltage of 200 kV. The TEM images of the coating film 1 obtained in Experimental Example 1 are shown in Fig. 3 to Fig. 5. As shown in Fig. 3 to Fig. 5, in the laminated parts 3, it could be confirmed that the black hard carbon layers B relatively shown in black and the white hard carbon layers W relatively shown in white are alternately laminated in the thickness direction. Further, it was confirmed that the white hard carbon layer W had a fine stripe pattern, and the black hard carbon layer B had a reticular or fan-shaped structural form in whole or in part. In addition, the carbon layer 4 was confirmed to consist of the black carbon layer 4a having a thickness of approximately 0.07 µm and the white carbon layer 4b having a thickness of approximately 0.12 µm and, in the white carbon layers 4b, the columnar structures 4c having the columnar vertical streaks relatively shown in black and extending in the thickness direction were confirmed. The surface layer part 5 appeared to have a fine-granular structural form.

The total thickness of the coating film 1, the thickness of each laminated part 3, the thickness of each carbon layer 4, and the thickness of the surface layer part 5 were determined from the bright-field TEM image. For thickness measurement, a piston ring with the coating film 1 formed near a center of an effective coating range of an arc ion plating device used, and a piston ring with the coating film 1 formed near an upper end and a lower end were adopted as measurement samples. It should be noted that the ratio (TB/TW) of the thickness TB of the black hard carbon layers B to the thickness TW of the white hard carbon layers W was 0.18/0.35 = 0.51.

### [Vickers Hardness and sp²/sp³ Ratio]

With regard to Vickers hardness, a Vickers hardness of the black hard carbon layer B was within a range of 700 to 1100 HV, and a Vickers hardness of the white hard carbon layer W was higher than a Vickers hardness of the adjacent black hard carbon layer B and within a range of 1200 to 1900 HV. A Vickers hardness of the surface layer part 5 was lower than the Vickers hardness of the white hard carbon layer W of the laminated part 3, which was the same white hard carbon layer, and within a range of 900 to 1200 HV.

It should be noted that the thickness T (= TB+TW) of the repeating unit 2 was 0.53 µm, the thickness of the black hard carbon layer B was 0.18 µm, the thickness of the white hard carbon layer W was 0.35 µm, and the thickness of the surface layer part 5 was 0.50 µm in this Experimental Example 1, each of these thicknesses being thin, and thus measurement of the Vickers hardness of each single layer in the cross section is almost impossible, even with the current highest-level measurement technology. Further, even if an attempt is made to measure the hardness from the surface, the measurement is affected by the hardness of the lower layer due to the thin thickness, making it difficult even with the current highest-level measurement technology. Therefore, the Vickers hardness here was evaluated on the basis of the results of thickly forming and measuring the black hard carbon layer B only, the white hard carbon layer W only, and the surface layer part 5 only, without changing the film forming conditions.

Specifically, because hardness depends on the film forming temperature, given TempB as the base material temperature at the end of film formation of the black hard carbon layer B accompanied by a temperature rise and TempW as the base material temperature at the end of film formation of the white hard carbon layer W accompanied by a temperature reduction, the magnitude relationship between the respective temperatures is TempB > TempW. In a case in which a single layer of the black hard carbon layer B was formed, the black hard carbon layer B was formed to 0.18 µm and subsequently cooled until the base material temperature dropped to TempW. Then, as soon as the base material temperature reached TempW, film formation of the black hard carbon layer B was started, and the film was formed to 0.18 µm. Subsequently, the cooling until the base material temperature dropped to TempW and the film formation of the black hard carbon layer B were repeated, obtaining a single-layer film with only the black hard carbon layers B being formed. On the other hand, in a case in which a single layer of the white hard carbon layer W was formed, the white hard carbon layer W was formed to 0.35 µm and subsequently heated by a heater until the base material temperature rose to TempB. Then, as soon as the base material temperature reached TempB, film formation of the white hard carbon layer W was started, and the film was formed to 0.35 µm. Subsequently, the heating until the base material temperature rose to TempB and the film formation of the white hard carbon layer W were repeated, obtaining a single-layer film with only the white hard carbon layer W being formed. In this way, in the measurement of hardness from the surface, the single-layer films of the black hard carbon layer B and the white hard carbon layer W, formed to film thicknesses not affected by the base material (6 µm or greater), were each adjusted to a surface roughness of about Ra 0.05 and measured for Vickers hardness from the surface layer at a load of 100 gf using a Vickers hardness meter. In this experimental example, evaluation was carried out by the Vickers hardness measured by this method. The surface layer part 5 was also measured for Vickers hardness by the same means.

The sp²/sp³ ratio of the laminated part 3 was within a range of 0.05 to 0.55 in each portion of the black hard carbon layers B, and within a range of 0.20 to 0.70 in each portion of the white hard carbon layers W. Further, the sp²/sp³ ratio of the white carbon layer 4b was within a range of 0.20 to 0.60 in each portion. Furthermore, the sp²/sp³ ratio of the surface layer part 5 was within a range of 0.40 to 0.55 in each portion of the surface layer part 5. It should be noted that the sp²/sp³ ratios of the black hard carbon layer B, the white hard carbon layer W, the white carbon layer 4b, and the surface layer part 5 were measured in each portion, but were not measured at the boundaries with other layers because the values may vary due to influence of other layers at the boundaries.

### [Wear Resistance, Chipping Resistance, Low Frictionality, and Peeling Resistance]

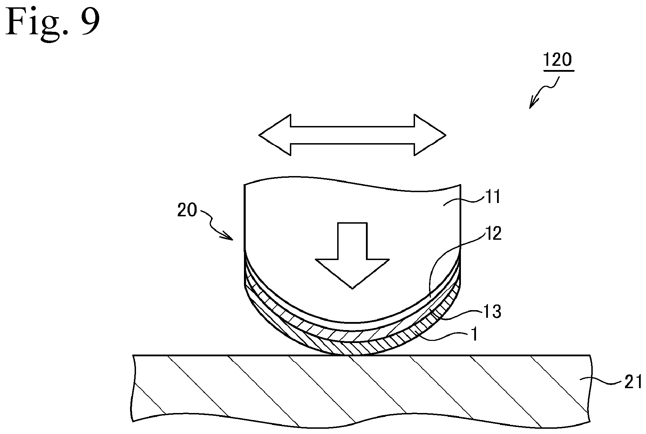

Various properties of the formed coating film 1 were obtained by a friction-abrasion testing method using a Schwingungs Reihungund und Verschleiss (SRV) tester 120 generally used in the evaluation of sliding members for automobiles. Specifically, with a sliding surface of a friction-abrasion testing sample 20 brought into contact with SUJ2 material serving as a sliding object 21 as illustrated in Fig. 9, the friction-abrasion testing sample 20 was reciprocally slid for 10 minutes and for 60 minutes while applying a load of 1000 N, by using 5W-30 (with Mo-DTC) as the lubricant, and the sliding surface thereof was observed under a microscope. In Fig. 9, reference sign 12 denotes the intermediate layer, and reference sign 1 denotes the coating film.

It was confirmed that the obtained coating film 1 exhibited constant and stable chipping resistance and wear resistance and had excellent peeling resistance (adhesion). Further, it was confirmed that chipping and cracking did not occur, particularly even in corner portions (also referred to as edge portions) where stress tends to accumulate.

As described above, the coating film 1 obtained in Experimental Example 1 had favorable chipping resistance and wear resistance and low aggressiveness against the mated material as well, and thus exhibited stable sliding properties with respect to both the coating film 1 and the mated material. In particular, even in the corner portions (also referred to as edge portions) where stress tends to accumulate, chipping and cracking did not occur due to the action of the carbon layers 4 provided between the laminated parts. Further, a cross-sectional form of each laminated part 3 appearing in the thickness direction Y of the coating film 1 was homogeneous, and thus properties in the thickness direction Y were also considered homogeneous, making it possible to realize both homogenization and thickening with favorable productivity. Further, these characteristics are particularly desirable for sliding members and coating films that are subject to high loads, such as piston rings, and make it possible to make sliding members with consistent and stable properties as compared with sliding members that do not have these characteristics. Furthermore, this coating film 1 includes the surface layer part 5 in the outermost surface and thus can realize a reduction in friction when brought into contact with a mated member in the initial stage of sliding.

### [Experimental Example 2]

A piston ring was applied as the sliding member 10 in this Experimental Example 2 as well, and the nitrided layer serving as the underlayer 12, the intermediate layer 13, and the initial carbon layer 14 were also formed as in Experimental Example 1 by using the same base material 11 as that in Experimental Example 1. The coating film 1 was obtained by forming the repeating unit 2 of the black hard carbon layer B and the white hard carbon layer W as in Experimental Example 1, forming a plurality of the laminated parts 3 having a predetermined thickness, forming the carbon layers 4 between the plurality of laminated parts 3, and finally forming the surface layer part 5.

In this Experimental Example 2, the film thickness was varied without changing the film forming conditions (bias voltage, arc current, film forming time). Specifically, the thickness of the repeating unit 2, which was constituted by the black hard carbon layer B and the white hard carbon layer W, was the same as in Experimental Example 1, the repeating unit 2 was repeatedly formed 17 times to form the laminated part 3 having a thickness of 9 µm, and this laminated part 3 was formed three times. The carbon layers 4 were formed to a thickness of 0.1 µm between the laminated parts 3. The surface layer part 5 was the same as in Experimental Example 1. A thickness of the coating film 1 was 27.7 µm. It should be noted that the carbon layer 4 was formed by the black carbon layer 4a having a thickness of approximately 0.05 µm and the white carbon layer 4b having a thickness of approximately 0.5 µm and, in the white carbon layers 4b, the columnar structures 4c having the columnar vertical streaks relatively shown in black and extending in the thickness direction were confirmed.

### [Evaluation of Experimental Example 2]

Evaluation of each property and the like is the same as that of the method described above. The bright-field TEM image of the cross section of the coating film 1 in Experimental Example 2 also showed a form similar to those in Fig. 3 to Fig. 5, with the only difference being the thickness ratio of the black carbon layer 4a and the white carbon layer 4b constituting the carbon layer 4.

The sp²/sp³ ratio of the laminated part 3 was within a range of 0.05 to 0.55 in each portion of the black hard carbon layers B, and within a range of 0.20 to 0.70 in each portion of the white hard carbon layers W. The sp²/sp³ ratio of the white carbon layer 4b was within a range of 0.20 to 0.60 in each portion. The sp²/sp³ ratio of the surface layer part 5 was within a range of 0.40 to 0.55.

It was confirmed that the obtained coating film 1 exhibited constant and stable chipping resistance and wear resistance and had excellent peeling resistance (adhesion). Further, it was confirmed that there chipping and cracking did not occur, particularly even in corner portions (also referred to as edge portions) where stress tends to accumulate.

### [Experimental Example 3]

A piston ring was applied as the sliding member 10 in this Experimental Example 3 as well, and the nitrided layer serving as the underlayer 12, the intermediate layer 13, and the initial carbon layer 14 were also formed as in Experimental Example 1 by using the same base material 11 as that in Experimental Example 1. The coating film 1 was obtained by forming the repeating unit 2 of the black hard carbon layer B and the white hard carbon layer W as in Experimental Example 1, forming a plurality of the laminated parts 3 having a predetermined thickness, forming the carbon layers 4 between the plurality of laminated parts 3, and finally forming the surface layer part 5.

In this Experimental Example 3 as well, the film thickness was varied without changing the film forming conditions (bias voltage, arc current, film forming time). Specifically, the thickness of the repeating unit 2, which was constituted by the black hard carbon layer B and the white hard carbon layer W, was the same as in Experimental Example 1, the repeating unit 2 was repeatedly formed 10 times to form the laminated part 3 having a thickness of 5.3 µm, and this laminated part 3 was formed two times. The carbon layers 4 were formed to a thickness of 0.19 µm between the laminated parts 3. The surface layer part 5 was the same as in Experimental Example 1. A thickness of the coating film 1 was 11.3 µm. It should be noted that the carbon layer 4 was formed by the black carbon layer 4a having a thickness of approximately 0.07 µm and the white carbon layer 4b having a thickness of approximately 0.12 µm and, in the white carbon layers 4b, the columnar structures 4c having the columnar vertical streaks relatively shown in black and extending in the thickness direction were confirmed.

### [Evaluation of Experimental Example 3]

Evaluation of each property and the like is the same as that of the method described above. The bright-field TEM image of the cross section of the coating film 1 in Experimental Example 3 also showed a form similar to those in Fig. 3 to Fig. 5, with the only difference being the thickness ratio of the black carbon layer 4a and the white carbon layer 4b constituting the carbon layer 4.

The sp²/sp³ ratio of the laminated part 3 was within a range of 0.05 to 0.55 in each portion of the black hard carbon layers B, and within a range of 0.20 to 0.70 in each portion of the white hard carbon layers W. The sp²/sp³ ratio of the white carbon layer 4b was within a range of 0.20 to 0.60 in each portion. The sp²/sp³ ratio of the surface layer part 5 was within a range of 0.40 to 0.55.

It was confirmed that the obtained coating film 1 exhibited constant and stable chipping resistance and wear resistance and had excellent peeling resistance (adhesion). Further, it was confirmed that chipping and cracking did not occur, particularly even in corner portions (also referred to as edge portions) where stress tends to accumulate.

### [Experimental Example 4]

In Experimental Example 4, the thickness of the surface layer part 5 (0.50 µm) in Experimental Example 1 was increased to 7 µm by extending the film forming time. All other conditions were the same as in Example 1, and the coating film 1 having a total thickness of 34.3 µm in Experimental Example 4 was formed. The obtained coating film 1 included the thick surface layer part 5, and thus was confirmed as having improved effectiveness as a conforming layer and as a film preventing damage to the aluminum bore, which was the mated member.

### [Comparative Experimental Example 1]

In this Comparative Experimental Example 1, a piston ring was applied as the sliding member 10, and the nitrided layer serving as the underlayer 12, the intermediate layer 13, and the initial carbon layer 14 were also formed as in Experimental Example 1 by using the same base material 11 as that in Experimental Example 1. The coating film 1 having a total thickness of 11.1 µm was obtained by forming the repeating unit 2 of the black hard carbon layer B and the white hard carbon layer W as in Experimental Example 1, but forming the repeating unit 2 20 times, and lastly forming the surface layer part 5. In this Comparative Experimental Example 1, a plurality of the laminated parts were formed as in Experimental Example 3. However, Comparative Experimental Example 1 differs in that the carbon layers 4 were not formed between the laminated parts 3. It should be noted that the film forming conditions of the black hard carbon layer B, the white hard carbon layer W, and the surface layer part 5 were the same as those in Experimental Example 1.

### [Evaluation of Comparative Experimental Example 1]

Evaluation of each property and the like is the same as that of the method described above. The obtained coating film 1 showed slight chipping and cracking in the corner portions (also referred to as edge portions) where stress tends to accumulate.

### [Comparative Experimental Example 2]

In this Comparative Experimental Example 2, a piston ring was applied as the sliding member 10, and the nitrided layer serving as the underlayer 12, the intermediate layer 13, and the initial carbon layer 14 were also formed as in Experimental Example 1 by using the same base material 11 as that in Experimental Example 1. The coating film 1 having a total thickness of 27.0 µm was obtained by forming the repeating unit 2 of the black hard carbon layer B and the white hard carbon layer W as in Experimental Example 1, but forming the repeating unit 2 50 times, and lastly forming the surface layer part 5. In this Comparative Experimental Example 2, a plurality of the laminated parts were formed as in Experimental Example 1. However, Comparative Experimental Example 1 differs in that the carbon layers 4 were not formed between the laminated parts 3. It should be noted that the film forming conditions of the black hard carbon layer B, the white hard carbon layer W, and the surface layer part 5 were the same as those in Experimental Example 1.

### [Evaluation of Comparative Experimental Example 2]

Evaluation of each property and the like is the same as that of the method described above. The obtained coating film 1 showed a slightly higher incidence of chipping and cracking in the corner portions (also referred to as edge portions) where stress tends to accumulate than in Comparative Experimental Example 1.

While the above has described the present invention on the basis of embodiments, the present invention is not limited to the embodiments described above. Various changes can be made to the embodiments described above within the same scope as and equivalent scope to the present invention.

### Descriptions of Reference Numerals

- 1: Coating film
- 2: Repeating unit
- 3: Laminated part
- 4: Carbon layer between laminated part (Inter-laminated-part carbon layer)
- 4a: Black carbon layer
- 4b: White carbon layer
- 4c: Columnar structure
- 5: Surface layer part
- 10: Sliding member (Piston ring)
- 11: Base material (Piston ring base material)
- 12: Underlayer
- 13: Intermediate layer
- 14: Carbon layer formed by bombardment treatment (Initial carbon layer)
- 15: Thin carbon layer (Laminated part inner carbon layer)
- 16: Sliding surface
- 20: Friction-abrasion testing sample
- 21: Sliding object
- 120: SRV tester
- B: Black hard carbon layer
- W: White hard carbon layer
- Y: Thickness direction
- X: In-plane direction
- TB: Thickness of black hard carbon layer
- TW: Thickness of white hard carbon layer
- T1: Thickness of coating film
- T2: Thickness of repeating unit
- T3: Thickness of laminated part
- T4: Thickness of carbon layer

## Claims

1. A sliding member comprising:
a coating film on a sliding surface on a base material,
the coating film including a plurality of laminated parts, and carbon layers provided between each of the plurality of laminated parts,
the plurality of laminated parts, when a cross section thereof is observed by a bright-field TEM image, being configured by laminating, in a thickness direction, repeating units of a black hard carbon layer shown in a relatively black color or blackish color and a white hard carbon layer shown in a relatively white color or whitish color, and the carbon layers each including a columnar structure.

2. The sliding member according to claim 1, wherein
each of the plurality of laminated parts has a thickness within a range of 2 to 9 µm, and the coating film has a thickness within a range of 4 to 40 µm.

3. The sliding member according to claim 1 or 2, wherein
the carbon layer is formed by a black carbon layer shown in a relatively black color or blackish color and a white carbon layer shown in a relatively white color or whitish color, in this order, and the columnar structure shown in the relatively black color or blackish color is present in the white carbon layer.

4. The sliding member according to claim 3, wherein
an [sp²/(sp²+sp³)] ratio of the black hard carbon layer is within a range of 0.05 to 0.75, an [sp²/(sp²+sp³)] ratio of the white hard carbon layer is larger than the [sp²/(sp²+sp³)] ratio of the black hard carbon layer and within a range of 0.20 to 0.80, and an [sp²/(sp²+sp³)] ratio of the white carbon layer in the carbon layer is within a range of 0.20 to 0.80.

5. The sliding member according to claim 1 or 2, wherein
an initial carbon layer is formed as a lower layer before formation of the coating layer.

6. The sliding member according to claim 1 or 2, wherein
a laminated part inner carbon layer is formed in each of the plurality of laminated parts, on the white hard carbon layer and as a lower layer of the black hard carbon layer.

7. The sliding member according to claim 1 or 2, further comprising:
a surface layer part serving as an outermost surface layer above the plurality of laminated parts, the surface layer part having a thickness of 0.1 to 10 µm.

8. The sliding member according to claim 1 or 2, wherein
the sliding member is a piston ring.

9. A coating film comprising:
a plurality of laminated parts; and
carbon layers provided between each of the plurality of laminated parts,
the plurality of laminated parts, when a cross section thereof is observed by a bright-field TEM image, being configured by laminating, in a thickness direction, repeating units of a black hard carbon layer shown in a relatively black color or blackish color and a white hard carbon layer shown in a relatively white color or whitish color, and the carbon layers each including a columnar structure.

10. The coating film according to claim 9, wherein
each of the plurality of laminated parts has a thickness within a range of 2 to 9 µm, and the coating film has a thickness within a range of 4 to 40 µm.

11. The coating film according to claim 9 or 10, wherein
the carbon layer is formed by a black carbon layer shown in a relatively black color or blackish color and a white carbon layer shown in a relatively white color or whitish color, in this order, and the columnar structure shown in the relatively black color or blackish color is present in the white carbon layer.

12. The coating film according to claim 9 or 10, wherein
an initial carbon layer is formed as a lower layer before formation of the coating film.

13. The coating film according to claim 9 or 10, wherein
a laminated part inner carbon layer is formed in the plurality of laminated parts, on the white hard carbon layer and as a lower layer of the black hard carbon layer.

14. The coating film according to claim 9 or 10, further comprising:
a surface layer part serving as an outermost surface layer above the plurality of laminated parts, the surface layer part having a thickness of 0.1 to 10 µm.

15. A manufacturing method of the sliding member according to claim 1 or 2 that includes the coating film on the sliding surface on the base material,
the coating film including a plurality of laminated parts, and carbon layers provided between each of the plurality of laminated parts, the plurality of laminated parts, when a cross section thereof is observed by a bright-field TEM image, being configured by laminating, in a thickness direction, repeating units of a black hard carbon layer shown in a relatively black color or blackish color and a white hard carbon layer shown in a relatively white color or whitish color, and the carbon layers each including a columnar structure, and
the carbon layers each being obtained by forming the plurality of laminated parts having a predetermined thickness, pausing film formation for a certain period of time to allow a temperature thereof to become relatively low, and then resuming film formation under predetermined conditions.
